# EUROPEAN PATENT APPLICATION

(11) **EP 3 771 217 A1**
(43) Date of publication of application: **27.01.2021**
(21) Application number: 19919550.4
(22) Date of filing: 30.12.2019
(51) Int. Cl.: H04N 21/426

(54) **5G TELEVISION, VIDEO PLAYING METHOD BASED ON 5G TELEVISION, AND READABLE STORAGE MEDIUM**

(30) Priority: 29.05.2019 CN 201910468132
(71) Applicant: Shenzhen Skyworth-Rgb Electronic Co., Ltd, Shenzhen, Guangdong 518057 (CN)
(72) Inventor: The designation of the inventor has not yet been filed
(74) Representative: Osterhoff, Utz
(86) International application number: PCT/CN2019/129837
(87) International publication number: WO 2020/238202

(57) **Abstract**

The present disclosure provides a 5G TV, a video playback method based on 5G TV and a computer readable storage medium. The 5G TV includes a 5G communication module, a decode module, and an audio and video playback module; the 5G communication module is connected to the decode module, and is configured to receive 5G audio and video signals and send the 5G audio and video signals to the decode module; and the decode module is connected to the audio and video playback module, and is configured to decode the received 5G audio and video signals to obtain audio data and video data, and is configured to send the audio data and the video data to the audio and video playback module, to make the audio and video playback module synchronously play the audio data and the video data. The present disclosure solves the technical problem that users in the community without wired broadband to the home cannot watch online videos on TV.

## Description

### CROSS-REFERENCE TO RELATED APPLICATIONS

This application claims priority to Chinese Application No. 201910468132.X, filed on May 29, 2019, entitled "5G TV, VIDEO PLAYBACK METHOD BASED ON 5G TV, AND READABLE STORAGE MEDIUM", the entire disclosure of which is incorporated herein by reference.

### TECHNICAL FIELD

The present disclosure relates to the technical field of smart TVs, in particular to a 5G TV, a video playback method based on 5G TV and a computer readable storage medium.

### BACKGROUND

Currently, affected by mobile network tariffs and technology, the transmission of network resources is transferred to the TV through the home broadband router. However, users in the community without wired broadband to the home cannot watch online videos on TV.

The above content is only used to assist the understanding of the technical solution of the present disclosure, and does not mean that the above content is recognized as prior art.

### SUMMARY

The main objective of the present disclosure is to provide a 5G TV, a video playback method based on 5G TV and a computer readable storage medium, aiming to solve the technical problem that users in the community without wired broadband to the home cannot watch online videos on TV.

In order to achieve the above objective, the present disclosure provides a 5G TV, including: a 5G communication module, a decode module, and an audio and video playback module,
the 5G communication module is connected to the decode module, and is configured to receive 5G audio and video signals and send the 5G audio and video signals to the decode module; and
the decode module is connected to the audio and video playback module, and is configured to decode the received 5G audio and video signals to obtain audio data and video data, and is configured to send the audio data and the video data to the audio and video playback module, to make the audio and video playback module synchronously play the audio data and the video data.

In an embodiment, the 5G communication module includes a 5G communication component, a 5G communication antenna, and a SIM card interface for connecting with a SIM card;
a first terminal of the 5G communication component is connected to the decode module as an output terminal of the 5G communication module, a second terminal of the 5G communication component is connected to the SIM card through the SIM card interface, the 5G communication component is configured to send an online request including identification information after receiving an online instruction sent by the decode module and the identification information fed back by the SIM card;
the 5G communication antenna is connected to a third terminal of the 5G communication component, and is configured to send the online request including the identification information to a base station after receiving the online request including the identification information sent by the 5G communication component, to make the 5G communication module and the base station connected to Internet; and
the 5G communication antenna is further configured to send the 5G audio and video signals received from the base station to the 5G communication component after successful networking, to make the 5G communication component send the 5G audio and video signals to the decode module through the first terminal.

In an embodiment, the decode module includes a video recognition unit, a decode unit, an audio processing unit, an on screen display (OSD) video synthesis unit, and a core processing unit;
the core processing unit is respectively connected to the output end of the 5G communication module, the video recognition unit, the decode unit, the audio processing unit, and the OSD video synthesis unit; the output end of the 5G communication module, the video recognition unit, the decode unit, and the OSD video synthesis unit are connected in sequence; the decode unit is connected to the audio processing unit; the OSD video synthesis unit is connected to the audio and video playback module as a first output end of the decode module; the audio processing unit is connected to the audio and video playback module as a second output end of the decode module;
the core processing unit is configured to control the video recognition unit to receive the 5G audio and video signals sent by the 5G communication component, and control the video recognition unit to recognize the 5G audio and video signals, to send recognized 5G audio and video signals to a corresponding decode unit;
the core processing unit is further configured to control the corresponding decode unit to decode the recognized 5G audio and video signals, to make the corresponding decode unit send the decoded audio data and video data to the audio processing unit and the OSD video synthesis unit;
the core processing unit is further configured to control the OSD video synthesis unit to superimpose an OSD layer on the received video data, to make the audio and video playback module play the video data of the superimposed OSD layer; and
the core processing unit is further configured to control the audio processing unit to process the received audio data, to make the audio and video module play the processed audio data.

In an embodiment, the decode unit further includes a 4K decode subunit and an 8K decode subunit;
the 4K decode subunit is configured to decode the 5G audio and video signals when the 5G audio and video signals sent by the video recognition unit are not 8K format; and
the 8K decode subunit is configured to decode the 5G audio and video signals when the 5G audio and video signals sent by the video recognition unit are the 8K format.

In an embodiment, the audio and video playback module includes a power amplifier unit and a display unit;
the display unit is connected to the OSD video synthesis unit, and is configured to receive the video data of the superimposed OSD layer sent by the OSD video synthesis unit, and play the video data of the superimposed OSD layer; and
the power amplifier unit is connected to the audio processing unit, and is configured to receive processed audio data sent by the audio processing unit, and play the processed audio data.

In an embodiment, the 5G TV further includes a frame rate conversion (FRC) frequency multiplication module,
the FRC frequency multiplication module is respectively connected to the OSD video synthesis unit and the display unit, and is configured to receive the video data of the superimposed OSD layer sent by the OSD video synthesis unit, and perform frequency multiplication processing on the video data of the superimposed OSD layer after the OSD video synthesis unit determines that a frame frequency of the video data sent by the decode unit is greater than a display frequency of the display unit, to make the display unit play the video data after the frequency multiplication processing.

Besides, in order to achieve the above objective, the present disclosure further provides a video playback method based on 5G TV, the method includes the following operations:
receiving a user's online request, and sending an online instruction to a 5G communication module according to the user's online request, to make the 5G communication module start a mobile network;
controlling the 5G communication module to receive 5G audio and video signals sent by a base station when the 5G communication module starts the mobile network, to make the 5G communication module send the 5G audio and video signals to a decode module;
controlling the decode module to decode the 5G audio and video signals to obtain video data and audio data; and
controlling the decode module to send the video data and the audio data to an audio and video playback module, to make the audio and video playback module synchronously play the received video data and audio data.

In an embodiment, the operation of receiving a user's online request, and sending an online instruction to a 5G communication module according to the user's online request, to make the 5G communication module start a mobile network includes:
receiving the user's online request, and sending a status acquisition request to the 5G communication module according to the user's online request, to make the 5G communication module feed back status information according to the status acquisition request, the status information including an online mode or an offline mode; and
sending the online instruction to the 5G communication module when the received status information is the online mode, to make the 5G communication module start the mobile network.

In an embodiment, after the operation of receiving the user's online request, and sending a status acquisition request to the 5G communication module according to the user's online request, to make the 5G communication module feed back status information according to the status acquisition request, the status information including an online mode or an offline mode, the method further includes:
sending a switching instruction to the 5G communication module when the received status information is the offline mode; and
controlling the 5G communication module to switch the offline mode to the online mode after receiving the switching instruction and feed back the status information including the online mode.

In addition, in order to achieve the above objective, the present disclosure further provides a computer readable storage medium, a computer program is stored on the computer readable storage medium, when the computer program is executed by a processor, the operations of the video playback method based on 5G TV are implemented.

The embodiments of the present disclosure provide a 5G TV, a video playback method based on 5G TV and a computer readable storage medium. The 5G TV includes a 5G communication module, a decode module, and an audio and video playback module. The 5G communication module is connected to the decode module, and is configured to receive 5G audio and video signals and send the 5G audio and video signals to the decode module; and the decode module is connected to the audio and video playback module, and is configured to decode the received 5G audio and video signals to obtain audio data and video data, and is configured to send the audio data and the video data to the audio and video playback module, to make the audio and video playback module synchronously play the audio data and the video data. Therefore, the TV can use the built-in 5G communication module to connect to the mobile network, obtain online video resources and play online videos on TV, so that users in communities without wired broadband to the home can also watch online videos on TV.

### BRIEF DESCRIPTION OF THE DRAWINGS

FIG. 1 is a schematic diagram of modules of a 5G TV according to an embodiment of the present disclosure.
FIG. 2 is a schematic diagram of modules of the 5G TV according to another embodiment of the present disclosure.
FIG. 3 is a schematic flowchart of a video playback method based on 5G TV according to a first embodiment of the present disclosure.

The realization of the objective, functional characteristics, and advantages of the present disclosure are further described with reference to the accompanying drawings.

**Description of reference numbers**

| Reference number | Name | Reference number | Name |
|---|---|---|---|
| 10 | 5G communication module | 11 | 5G communication antenna |
| 12 | 5G communication component | 13 | SIM card interface |
| 20 | decode module | 21 | video recognition unit |
| 22 | decode unit | 23 | OSD video synthesis unit |
| 24 | audio processing unit | 25 | core processing unit |
| 26 | 4K decode subunit | 27 | 8K decode subunit |
| 30 | audio and video playback module | 31 | display unit |
| 32 | power amplifier unit | 40 | FRC frequency multiplication module |

### Detailed description of the embodiments

It should be understood that the specific embodiments described here are only used to explain the present disclosure, and are not used to limit the present disclosure.

The technical solutions of the embodiments of the present disclosure will be described in more detail below with reference to the accompanying drawings. It is obvious that the embodiments to be described are only some rather than all of the embodiments of the present disclosure. All other embodiments obtained by persons skilled in the art based on the embodiments of the present disclosure without creative efforts shall fall within the scope of the present disclosure.

It should be noted that all the directional indications (such as up, down, left, right, front, rear...) in the embodiments of the present disclosure are only used to explain the relative positional relationship, movement, etc. of the components in a certain posture (as shown in the drawings). If the specific posture changes, the directional indication will change accordingly.

Besides, the descriptions associated with, e.g., "first" and "second," in the present disclosure are merely for descriptive purposes, and cannot be understood as indicating or suggesting relative importance or impliedly indicating the number of the indicated technical feature. Therefore, the feature associated with "first" or "second" can expressly or impliedly include at least one such feature. In addition, the technical solutions between the various embodiments can be combined with each other, but they must be based on the realization of those of ordinary skill in the art. When the combination of technical solutions is contradictory or cannot be achieved, it should be considered that such a combination of technical solutions does not exist, nor does it fall within the scope of the present disclosure.

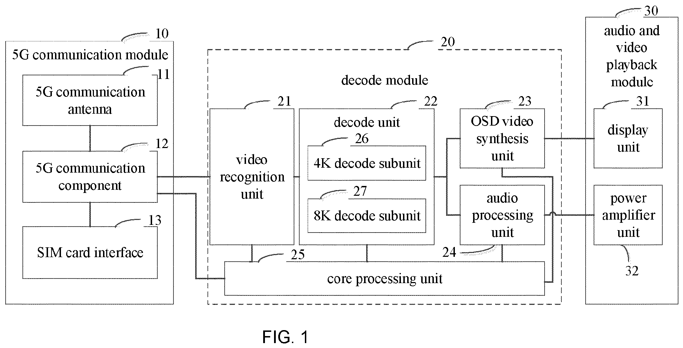

As shown in FIG. 1, in a 5G TV according to a first embodiment of the present disclosure, the 5G TV includes a 5G communication module 10, a decode module 20, and an audio and video playback module 30.

The 5G communication module 10 is connected to the decode module 20, and is configured to receive 5G audio and video signals and send the 5G audio and video signals to the decode module 20; and the decode module 20 is connected to the audio and video playback module 30, and is configured to decode the received 5G audio and video signals to obtain audio data and video data, and is configured to send the audio data and the video data to the audio and video playback module 30, to make the audio and video playback module 30 synchronously play the audio data and the video data.

In this embodiment, the decode module 20 and the 5G communication module 10 in the 5G TV can be connected and data transmitted through a high-speed USB interface. The decode module 20 and the audio and video playback module 30 can be connected and data transmitted through a V-by-ONE interface. When the 5G communication module 10 receives the 5G audio and video signals sent by the base station, the 5G communication module 10 transmits the 5G audio and video signals to the decode module 20 through the high-speed USB interface. After receiving the 5G audio and video signals, the decode module 20 performs audio and video type recognition, decoding, image and audio enhancement and other processing to obtain the final audio data and video data. The audio data and video data are transmitted to the audio and video playback module 30 through the V-by-ONE interface. After receiving the audio data and video data, the audio and video playback module 30 synchronously plays the audio data and the video data. Through the combined design of 5G communication module 10, decode module 20, audio and video playback module 30, etc., the TV can use the built-in 5G communication module 10 to connect to the mobile network, obtain network video resources, and play the network video on the TV, so that users in the community without wired broadband to the home can also watch the network video on TV.

It should be noted that in addition to the high-speed USB interface for communicating with the 5G communication module 10, the decode module 20 also includes an HDMI 2.1 input interface and a USB 3.0 interface to meet the input requirements of the whole machine for 8K signals. The 5G TV can also include a WIFI module, which can not only accept the wireless network of the surrounding environment, but also can be used as a hotspot instead of a router. When it is a hotspot, other terminals can surf the Internet through the 5G TV, which is convenient for audiences in various situations, and provides a variety of connection methods for the TV, which is highly intelligent.

Further, as shown in FIG. 1, the 5G communication module 10 includes a 5G communication component 12, a 5G communication antenna 11, and a SIM card interface 13 for connecting with a SIM card;

A first terminal of the 5G communication component 12 is connected to the decode module 20 as an output end of the 5G communication module 10, a second terminal of the 5G communication component 12 is connected to the SIM card through the SIM card interface 13, the 5G communication component 12 is configured to send an online request including identification information after receiving an online instruction sent by the decode module 20 and the identification information fed back by the SIM card;
the 5G communication antenna 11 is connected to a third terminal of the 5G communication component 12, and is configured to send the online request including the identification information to a base station after receiving the online request including the identification information sent by the 5G communication component 12, to make the 5G communication module 10 and the base station connected to Internet; and
the 5G communication antenna 11 is further configured to send the 5G audio and video signals received from the base station to the 5G communication component 12 after successful networking, to make the 5G communication component 12 send the 5G audio and video signals to the decode module 20 through the first terminal.

The 5G communication component 12 may adopt the 5GRG500Q module of Quectel, or other 5G modules. After receiving the online instruction sent by the decode module 20, the 5G communication component 12 may obtain the identification information ISMI of the SIM card through the USIM1_DATA (data pin) on the SIM card interface 13, and send the online request including the ISMI to the 5G communication antenna 11. The 5G communication antenna 11 sends the online request including ISMI to the base station. After the base station determines that the ISMI in the online request is valid, the 5G communication antenna 11 will receive a random number RAND sent by the base station, and then transmit the random number to the 5G communication component 12. The 5G communication component 12 may transmit the random number to the SIM card through the USIM1_DATA (data pin) on the SIM card interface 13. The SIM card obtains a response number SRES by performing an authentication algorithm on the random number, and transmits the SRES to the 5G communication component 12 through USIM1_DATA (data pin). The 5G communication component 12 then sends the SRES to the base station through the 5G communication antenna 11. After the base station determines that the SRES is valid, the base station is connected to the 5G communication antenna 11. After successfully networking, the 5G communication antenna 11 receives the 5G audio and video signals sent by the base station, and transmits the 5G audio and video signals to the 5G communication component 12. The 5G communication component 12 parses the 5G audio and video signals to obtain 5G audio and video information, and sends the 5G audio and video information to the decode module 20 through the high-speed USB interface.

It should be noted that in addition to USIM1_DATA (data pin), there are multiple other pins on the SIM card interface 13, including USIM1_VDD (card power supply pin), USIM1_RESET (card reset signal pin), USIM1_CLK (clock signal pin) and USIM1_DET (card detection pin). When the 5G communication component 12 detects that the SIM card type inserted by the user is a 3.3V power supply type SIM card through the USIM1_DET on the SIM card interface 13, the 5G communication component 12 outputs 3.3V for the SIM card through the USIM1_VDD on the SIM card interface 13. When the 5G communication component 12 detects that the SIM card type inserted by the user is a 1.8V power supply type SIM card through the USIM1_DET on the SIM card interface 13, the 5G communication component 12 outputs 1.8V for the SIM card through the USIM1_VDD on the SIM card interface 13.

The 5G communication antenna 11 includes multiple groups of antennas, which are divided according to mobile frequency bands. In order to increase the transmission rate, Multiple-Input Multiple-Output (MIMO) technology is adopted to correspond to the transmission and reception of mobile signals in three groups of frequency bands. Antenna ANT_TRX2 is the main antenna, corresponding to the frequency bands 2500-2700MHz and 3300-5000MHz frequency signal uplink and downlink. ANT_TRX3 is the second 5G antenna, corresponding to frequency bands 2500-2700MHz and 3300-5000MHz frequency signal uplink and downlink. Antenna ANT_TRX1 corresponds to the frequency band 600-2690MHz frequency signal uplink and downlink. ANT_DIV1 corresponds to the frequency band 600-2690MHz frequency signal downlink. Antenna ANT_DIV2 corresponds to the frequency bands 1400-2690MHz and 3300-5000MHz frequency signal downlink. ANT_DIV3 corresponds to the frequency bands 1400-2690MHz and 3300-5000MHz frequency signal downlink.

Further, as shown in FIG. 1, the decode module 20 includes a video recognition unit 21, a decode unit 22, an audio processing unit 24, an on screen display (OSD) video synthesis unit 23, and a core processing unit 25.

The core processing unit 25 is respectively connected to the output end of the 5G communication module 10, the video recognition unit 21, the decode unit 22, the audio processing unit 24, and the OSD video synthesis unit 23; the output end of the 5G communication module 10, the video recognition unit 21, the decode unit 22, and the OSD video synthesis unit 23 are connected in sequence; the decode unit 22 is connected to the audio processing unit 24; the OSD video synthesis unit 23 is connected to the audio and video playback module 30 as a first output end of the decode module 20; the audio processing unit 24 is connected to the audio and video playback module 30 as a second output end of the decode module 20.

The core processing unit 25 is configured to control the video recognition unit 21 to receive the 5G audio and video signals sent by the 5G communication component 12, and control the video recognition unit 21 to recognize the 5G audio and video signals, to send the recognized 5G audio and video signals to a corresponding decode unit 22.

The core processing unit 25 is further configured to control the corresponding decode unit 22 to decode the recognized 5G audio and video signals, to make the corresponding decode unit 22 send the decoded audio data and video data to the audio processing unit 24 and the OSD video synthesis unit 23.

The core processing unit 25 is further configured to control the OSD video synthesis unit 23 to superimpose an OSD layer on the received video data, to make the audio and video playback module 30 play the video data of the superimposed OSD layer.

The core processing unit 25 is further configured to control the audio processing unit 24 to process the received audio data, to make the audio and video module play the processed audio data.

When the video recognition unit 21 receives the parsed 5G audio and video information sent by the 5G communication component 12, the core processing unit 25 controls the video recognition unit 21 to recognize the type of the audio and video information, and controls the video recognition unit 21 to send the recognized audio and video information to the corresponding decode unit 22 for decoding. When the decode unit 22 receives the recognized audio and video information, the core processing unit 25 controls the decode unit 22 to obtain the audio data and video data after decoding the audio and video information, and controls the decode unit 22 to directly send the audio data to the audio processing unit 24. The core processing unit 25 also controls the decode unit 22 to perform image enhancement processing on the video data, so that the video data after the image enhancement processing is sent to the OSD video synthesis unit 23. When the audio processing unit 24 receives the audio data, the core processing unit 25 controls the audio processing unit 24 to process the audio data (such as sound quality improvement, noise reduction, etc.), so that the audio and video module plays the processed audio data. For the decoded video data, the decode unit 22 also performs image enhancement processing on the video data, and sends the image enhancement processing video data to the OSD video synthesis unit 23. After the OSD video synthesis unit 23 receives the video data processed by the image enhancement process, it superimposes an OSD layer on the video data processed by the image enhancement process to obtain the video data of the superimposed OSD layer, and send the video data of the superimposed OSD layer to the audio and video playback module 30.

It should be noted that each unit in the decode module 20 transmits data and signals through a V-BY-ONE interface. In the current protocol standard, the signal that can be transmitted by a group of 8 LANE V-BY-ONE interface signals is 4K/60HZ signals. To transmit 8K/60HZ signals, 4 groups of 8 LANE V-BY-ONE interfaces are required.

A pin connection is provided between the core processing unit 25 and the 5G communication component 12 as the output end of the 5G communication module 10. The core processing unit 25 sends an online instruction to the 5G communication component 12 through its pins to control the 5G communication component 12 to enter the online mode or send an offline instruction to control the 5G communication component 12 to enter the offline mode. The core processing unit 25 also send a status acquisition request to the 5G communication component 12 through the pins, such that the 5G communication component 12 feeds back to the core processing unit 25 through pins whether the current working mode of the 5G communication component 12 is the online mode or the offline mode. For example, DISABLE pin is a pin for the decode module 20 to control the working status of the 5G component. When the core processing unit 25 sets the DISABLE pin to a low level, the 5G component enters the offline mode, and when the DISABLE pin is set to a high level, the 5G component enters the online mode.

Further, as shown in FIG. 1, the decode unit 22 further includes a 4K decode subunit 26 and an 8K decode subunit 27. The 4K decode subunit 26 is configured to decode the 5G audio and video signals when the 5G audio and video signals sent by the video recognition unit 21 are not 8K format; and the 8K decode subunit 27 is configured to decode the 5G audio and video signals when the 5G audio and video signals sent by the video recognition unit 21 are the 8K format.

Further, as shown in FIG. 1, the audio and video playback module 30 includes a display unit 31 and a power amplifier unit 32. The display unit 31 is connected to the OSD video synthesis unit 23, and is configured to receive the video data of the superimposed OSD layer sent by the OSD video synthesis unit 23, and play the video data of the superimposed OSD layer; and the power amplifier unit 32 is connected to the audio processing unit 24, and is configured to receive processed audio data sent by the audio processing unit 24, and play the processed audio data.

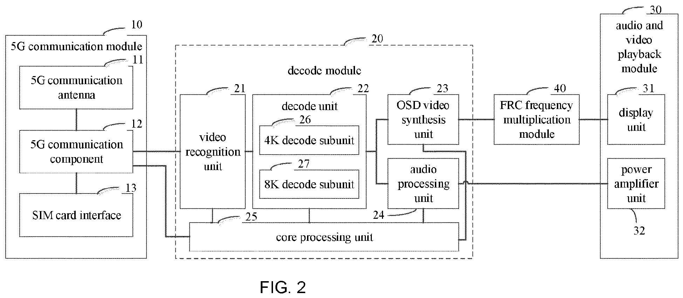

In an embodiment, as shown in FIG. 2, the 5G TV further includes a frame rate conversion (FRC) frequency multiplication module 40. The FRC frequency multiplication module 40 is respectively connected to the OSD video synthesis unit 23 and the display unit 31.

After the OSD video synthesis unit 23 determines that a frame frequency of the video data sent by the decode unit 22 is greater than a display frequency of the display unit 31, the FRC frequency multiplication module 40 performs frequency multiplication processing on the video data of the superimposed OSD layer received from the OSD video synthesis unit 23. Therefore, the frequency of the video data is increased to be the same as the frequency of the display unit 31, and then the frequency-multiplied video data is sent to the display unit 31 so that the display unit 31 plays the frequency-multiplied video data. For example, when the OSD video synthesis unit 23 receives that the video data sent by the decode unit 22 is 8K/60HZ, and the display unit 31 is 120HZ, the FRC frequency multiplication module 40 performs frequency multiplication processing on the video data, converts the 8K/60HZ video data into 8K/120HZ video data, and then sends the 8K/120HZ video data to the display unit 31. By adding the FRC frequency multiplication module 40 between the OSD video synthesis unit 23 and the display unit 31, the FRC frequency multiplication module 40 is configured to increase the frequency of the video data lower than the frequency of the display unit 31 to be consistent with the frequency of the display unit 31, thus, the picture in the process of playing the video data on the display unit 31 is smoother.

It should be noted that when the OSD video synthesis unit 23 determines that the frame frequency of the video data sent by the decode unit 22 is not greater than the display frequency of the display unit 31, the OSD video synthesis unit 23 superimposes the OSD layer on the video data, and then directly sends the video data of the superimposed OSD layer to the display unit 31, so that the display unit 31 plays the video data of the superimposed OSD layer.

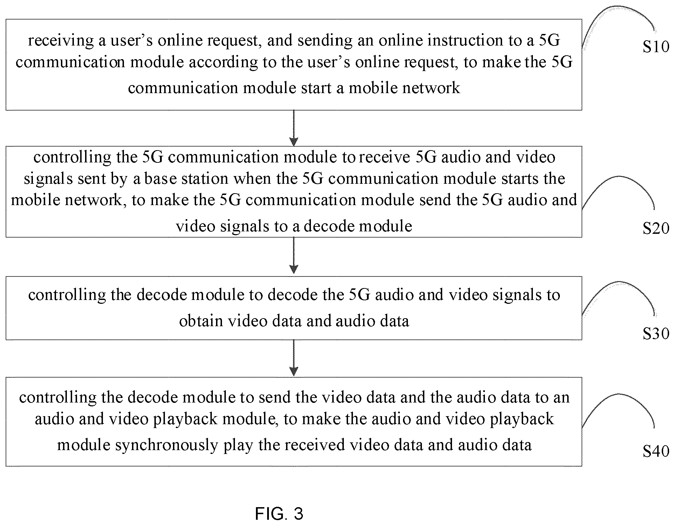

As shown in FIG. 3, in the first embodiment of the video playback method based on 5G TV of the present disclosure, which is applied to a 5G TV, the video playback method based on 5G TV includes the following operations:
Operation S10, receiving a user's online request, and sending an online instruction to a 5G communication module according to the user's online request, to make the 5G communication module start a mobile network;
Operation S20, controlling the 5G communication module to receive 5G audio and video signals sent by a base station when the 5G communication module starts the mobile network, to make the 5G communication module send the 5G audio and video signals to a decode module;
Operation S30, controlling the decode module to decode the 5G audio and video signals to obtain video data and audio data; and

Operation S40, controlling the decode module to send the video data and the audio data to an audio and video playback module, to make the audio and video playback module synchronously play the received video data and audio data.

As shown in FIG. 1, in this embodiment, the 5G TV includes a 5G communication module 10, a decode module 20, and an audio and video playback module 30. The 5G communication module 10, the decode module 20, and the audio and video playback module 30 are connected in sequence. The core processing unit 25 uses various interfaces and lines to connect to the 5G communication module 10, the decode module 20, and the audio and video playback module 30 respectively, and controls the 5G communication module 10, the decode module 20 and the audio and video playback module 30 to coordinate work. The core processing unit 25 can be used as a unit in the decode module 20 or as an independent unit in the 5G TV.

When the user needs to go online, an online request is sent to the core processing unit 25. After receiving the online request, the core processing unit 25 sends a status acquisition request to the 5G communication module 10. The 5G communication module 10 feeds back the current status information of the 5G communication module 10 to the core processing unit 25 after receiving the status acquisition request, and the status information may be an online mode or an offline mode. If the current status of the 5G communication module 10 is online mode, after receiving the feedback status information of the 5G communication module 10 that the 5G communication module 10 is the online mode, the core processing unit 25 sends an online instruction to the 5G communication module 10 to control the 5G communication module 10 to start the 5G mobile network.

If the current status of the 5G communication module 10 is the offline mode, the core processing unit 25 sends a switching instruction to the 5G communication module 10 when receiving the feedback that the 5G communication module 10 is the offline mode. After receiving the switching instruction, the 5G communication module 10 switches the offline mode to the online mode, and feeds back the status information of the switched online mode to the core processing unit 25. After receiving the feedback status information of the 5G communication module 10 that the 5G communication module 10 is the online mode, the core processing unit 25 sends an online instruction to the 5G communication module 10 to control the 5G communication module 10 to start the 5G mobile network.

After the 5G TV is connected to the 5G mobile network, the core processing unit 25 controls the 5G communication module 10 to receive the 5G audio and video signals sent by the mobile network base station, to send the 5G audio and video signals to the decode module 20. After the decode module 20 receives the 5G audio and video signals, the core processing unit 25 controls the decode module 20 to decode the 5G audio and video signals to obtain audio data and video data, and controls the decode module 20 to send the video data and the audio data to the audio and video playback module 30. After the audio and video module receives the video data and audio data, when the core processing unit 25 receives the playback instruction input by the user, the core processing unit 25 controls the audio module to synchronously play the received audio data and video data.

It should be noted that the mobile network can also be a 4G network, a 3G network, or a 2G network.

In this embodiment, receiving a user's online request, and sending an online instruction to a 5G communication module 10 according to the user's online request, to make the 5G communication module 10 start a mobile network; controlling the 5G communication module 10 to receive 5G audio and video signals sent by a base station when the 5G communication module 10 starts the mobile network, to make the 5G communication module 10 send the 5G audio and video signals to a decode module 20; controlling the decode module 20 to decode the 5G audio and video signals to obtain video data and audio data; and controlling the decode module 20 to send the video data and the audio data to an audio and video playback module 30, to make the audio and video playback module 30 synchronously play the received video data and audio data. Thus, the TV can use the built-in 5G communication module 10 to connect to the mobile network and play the obtained network video, so that users in the community without wired broadband to the home can also watch the network video on TV. Compared with the traditional 4G and 3G, the 5G network has lower latency, faster data transmission rate and lower cost, and is more suitable for ultra-high-definition video transmission, download and playback.

Besides, it should also be noted that the detailed processing and transmission process of the decode module 20, the 5G communication module 10, and the audio and video playback module 30 in the video playback method based on 5G TV can be performed with reference to the embodiment of the 5G TV, and will not be repeated here.

The present disclosure further provides a computer readable storage medium on which a computer program is stored. The computer readable storage medium may be a memory not shown in the smart 5G TV in FIG. 1, or may be at least one of ROM (Read-Only Memory)/RAM (Random Access Memory), magnetic disk, and optical disk. The computer-readable storage medium includes a number of information to enable the smart 5G TV to execute the method described in each embodiment of the present disclosure.

It should be noted that in this document, the terms "comprise", "include" or any other variants thereof are intended to cover a non-exclusive inclusion. Thus, a process, method, article, or system that includes a series of elements not only includes those elements, but also includes other elements that are not explicitly listed, or also includes elements inherent to the process, method, article, or system. If there are no more restrictions, the element defined by the sentence "including a..." does not exclude the existence of other identical elements in the process, method, article or system that includes the element.

The serial numbers of the foregoing embodiments of the present disclosure are only for description, and do not represent the advantages and disadvantages of the embodiments.

Through the description of the above embodiment, those skilled in the art can clearly understand that the above-mentioned embodiments can be implemented by software plus a necessary general hardware platform, of course, it can also be implemented by hardware, but in many cases the former is a better implementation.

The above are only some embodiments of the present disclosure, and do not limit the scope of the present disclosure thereto. Under the inventive concept of the present disclosure, equivalent structural transformations made according to the description and drawings of the present disclosure, or direct/indirect application in other related technical fields are included in the scope of the present disclosure.

## Claims

1. A 5G TV, comprising: a 5G communication module, a decode module, and an audio and video playback module, wherein:
the 5G communication module is connected to the decode module, and is configured to receive 5G audio and video signals and send the 5G audio and video signals to the decode module; and
the decode module is connected to the audio and video playback module,
and is configured to decode the received 5G audio and video signals to obtain audio data and video data, and is configured to send the audio data and the video data to the audio and video playback module, to make the audio and video playback module synchronously play the audio data and
the video data.

2. The 5G TV of claim 1, wherein:
the 5G communication module comprises a 5G communication component, a 5G communication antenna, and a SIM card interface for connecting with a SIM card;
a first terminal of the 5G communication component is connected to the decode module as an output terminal of the 5G communication module, a second terminal of the 5G communication component is connected to the SIM card through the SIM card interface, the 5G communication component is configured to send an online request comprising identification information after receiving an online instruction sent by the decode module and the identification information fed back by the SIM card;
the 5G communication antenna is connected to a third terminal of the 5G communication component, and is configured to send the online request comprising the identification information to a base station after receiving the online request comprising the identification information sent by the 5G communication component, to make the 5G communication module and the base station connected to Internet; and
the 5G communication antenna is further configured to send the 5G audio and video signals received from the base station to the 5G communication component after successful networking, to make the 5G communication component send the 5G audio and video signals to the decode module through the first terminal.

3. The 5G TV of claim 2, wherein:
the SIM card interface comprises a card power supply pin and a card detection pin;
the 5G communication module is configured to detect a power supply type of the SIM card through the card detection pin, and output a voltage corresponding to the power supply type of the SIM card to the SIM card through the card power supply pin according to the detected power supply type of the SIM card.

4. The 5G TV of claim 2, wherein:
the decode module comprises a video recognition unit, a decode unit, an audio processing unit, an on screen display (OSD) video synthesis unit, and a core processing unit;
the core processing unit is respectively connected to the output end of the 5G communication module, the video recognition unit, the decode unit, the audio processing unit, and the OSD video synthesis unit; the output end of the 5G communication module, the video recognition unit, the decode unit, and the OSD video synthesis unit are connected in sequence; the decode unit is connected to the audio processing unit; the OSD video synthesis unit is connected to the audio and video playback module as a first output end of the decode module; the audio processing unit is connected to the audio and video playback module as a second output end of the decode module;
the core processing unit is configured to control the video recognition unit to receive the 5G audio and video signals sent by the 5G communication component, and control the video recognition unit to recognize the 5G audio and video signals, to send recognized 5G audio and video signals to a corresponding decode unit;
the core processing unit is further configured to control the corresponding decode unit to decode the recognized 5G audio and video signals, to make the corresponding decode unit send the decoded audio data and
video data to the audio processing unit and the OSD video synthesis unit;
the core processing unit is further configured to control the OSD video synthesis unit to superimpose an OSD layer on the received video data, to make the audio and video playback module play the video data of the superimposed OSD layer; and
the core processing unit is further configured to control the audio processing unit to process the received audio data, to make the audio and video module play the processed audio data.

5. The 5G TV of claim 4, wherein:
the core processing unit is connected to the 5G communication component through a pin;
the core processing unit is configured to send an online instruction or an offline instruction to the 5G communication component through the pin to control the 5G communication component to enter an online mode or an offline mode correspondingly; and
the core processing unit is further configured to send a status acquisition request to the 5G communication component through the pin, to make the 5G communication component feed back a current working mode through the pin, the working mode comprises the online mode and the offline mode.

6. The 5G TV of claim 4, wherein:
the decode unit further comprises a 4K decode subunit and an 8K decode subunit;
the 4K decode subunit is configured to decode the 5G audio and video signals when the 5G audio and video signals sent by the video recognition unit are not 8K format; and
the 8K decode subunit is configured to decode the 5G audio and video signals when the 5G audio and video signals sent by the video recognition unit are the 8K format.

7. The 5G TV of claim 4, wherein:
the audio and video playback module comprises a power amplifier unit and a display unit;
the display unit is connected to the OSD video synthesis unit, and is configured to receive the video data of the superimposed OSD layer sent by the OSD video synthesis unit, and play the video data of the superimposed OSD layer; and
the power amplifier unit is connected to the audio processing unit, and is configured to receive processed audio data sent by the audio processing unit, and play the processed audio data.

8. The 5G TV of claim 7, further comprising a frame rate conversion (FRC) frequency multiplication module, wherein:
the FRC frequency multiplication module is respectively connected to the OSD video synthesis unit and the display unit, and is configured to receive the video data of the superimposed OSD layer sent by the OSD video synthesis unit, and perform frequency multiplication processing on the video data of the superimposed OSD layer after the OSD video synthesis unit determines that a frame frequency of the video data sent by the decode unit is greater than a display frequency of the display unit, to make the display unit play the video data after the frequency multiplication processing.

9. A video playback method based on 5G TV, comprising the following operations:
receiving a user's online request, and sending an online instruction to a 5G communication module according to the user's online request, to make the 5G communication module start a mobile network;
controlling the 5G communication module to receive 5G audio and video signals sent by a base station when the 5G communication module starts the mobile network, to make the 5G communication module send the 5G audio and video signals to a decode module;
controlling the decode module to decode the 5G audio and video signals to obtain video data and audio data; and
controlling the decode module to send the video data and the audio data to an audio and video playback module, to make the audio and video playback module synchronously play the received video data and audio data.

10. The video playback method based on 5G TV of claim 9, wherein the operation of receiving a user's online request, and sending an online instruction to a 5G communication module according to the user's online request, to make the 5G communication module start a mobile network comprises:
receiving the user's online request, and sending a status acquisition request to the 5G communication module according to the user's online request, to make the 5G communication module feed back status information according to the status acquisition request, the status information comprising an online mode or an offline mode; and
sending the online instruction to the 5G communication module when the received status information is the online mode, to make the 5G communication module start the mobile network.

11. The video playback method based on 5G TV of claim 10, wherein after the operation of receiving the user's online request, and sending a status acquisition request to the 5G communication module according to the user's online request, to make the 5G communication module feed back status information according to the status acquisition request, the status information comprising an online mode or an offline mode, the method further comprises:
sending a switching instruction to the 5G communication module when the received status information is the offline mode; and
controlling the 5G communication module to switch the offline mode to the online mode after receiving the switching instruction and feed back the status information comprising the online mode.

12. The video playback method based on 5G TV of claim 11, wherein the decode module comprises a decode unit and a video recognition unit;
the operation of controlling the decode module to decode the 5G audio and video signals to obtain video data and audio data comprises:
controlling the video recognition unit to recognize the 5G audio and video signals to send the recognized 5G audio and video signals to a corresponding decode unit; and
controlling the corresponding decode unit to decode the recognized 5G audio and video signals to obtain the audio data and the video data.

13. The video playback method based on 5G TV of claim 12, wherein the decode module further comprises an audio processing unit and a OSD video synthesis unit;
the operation of controlling the decode module to send the video data and the audio data to an audio and video playback module, to make the audio and video playback module synchronously play the received video data and audio data comprises:
controlling the corresponding decode unit to send the decoded audio data and video data to the audio processing unit and the OSD video synthesis unit;
controlling the OSD video synthesis unit to superimpose OSD layer on the received video data, and send the video data of the superimposed OSD layer to the audio and video playback module, to make the audio and
video playback module play the video data of the superimposed OSD layer; and
controlling the audio processing unit to process the received audio data, and send the processed audio data to the audio and video playback module, to make the audio and video module play the processed audio data.

14. The video playback method based on 5G TV of claim 12, wherein the decode unit further comprises a 4K decode subunit and an 8K decode subunit;
the operation of controlling the video recognition unit to recognize the 5G audio and video signals to send the recognized 5G audio and video signals to a corresponding decode unit comprises:
controlling the video recognition unit to recognize the 5G audio and video signals;
controlling the video recognition unit to send the 5G audio and video signals to the 4K decode subunit when the 5G audio and video signals are not 8K format; and
controlling the video recognition unit to send the 5G audio and video signals to the 8K decode subunit when the 5G audio and video signals are the 8K format.

15. A computer readable storage medium, wherein a computer program is stored on the computer readable storage medium, the computer program, when executed by a processor, implements the following operations:
receiving a user's online request, and sending an online instruction to a 5G communication module according to the user's online request, to make the 5G communication module start a mobile network;
controlling the 5G communication module to receive 5G audio and video signals sent by a base station when the 5G communication module starts the mobile network, to make the 5G communication module send the 5G audio and video signals to a decode module;
controlling the decode module to decode the 5G audio and video signals to obtain video data and audio data; and
controlling the decode module to send the video data and the audio data to an audio and video playback module, to make the audio and video playback module synchronously play the received video data and audio data.

16. The computer readable storage medium of claim 15, wherein the operation of receiving a user's online request, and sending an online instruction to a 5G communication module according to the user's online request, to make the 5G communication module start a mobile network comprises:
receiving the user's online request, and sending a status acquisition request to the 5G communication module according to the user's online request, to make the 5G communication module feed back status information according to the status acquisition request, the status information comprising an online mode or an offline mode; and
sending the online instruction to the 5G communication module when the received status information is the online mode, to make the 5G communication module start the mobile network.

17. The computer readable storage medium of claim 16, wherein after the operation of receiving the user's online request, and sending a status acquisition request to the 5G communication module according to the user's online request, to make the 5G communication module feed back status information according to the status acquisition request, the status information comprising an online mode or an offline mode, further comprising:
sending a switching instruction to the 5G communication module when the received status information is the offline mode; and
controlling the 5G communication module to switch the offline mode to the online mode after receiving the switching instruction and feed back the status information comprising the online mode.

18. The computer readable storage medium of claim 17, wherein the decode module comprises a decode unit and a video recognition unit;
the operation of controlling the decode module to decode the 5G audio and video signals to obtain video data and audio data comprises:
controlling the video recognition unit to recognize the 5G audio and video signals to send the recognized 5G audio and video signals to a corresponding decode unit; and
controlling the corresponding decode unit to decode the recognized 5G audio and video signals to obtain the audio data and the video data.

19. The computer readable storage medium of claim 18, wherein the decode module further comprises an audio processing unit and a OSD video synthesis unit;
the operation of controlling the decode module to send the video data and the audio data to an audio and video playback module, to make the audio and video playback module synchronously play the received video data and audio data comprises:
controlling the corresponding decode unit to send the decoded audio data and video data to the audio processing unit and the OSD video synthesis unit;
controlling the OSD video synthesis unit to superimpose OSD layer on the received video data, and send the video data of the superimposed OSD layer to the audio and video playback module, to make the audio and
video playback module play the video data of the superimposed OSD layer; and
controlling the audio processing unit to process the received audio data, and send the processed audio data to the audio and video playback module, to make the audio and video module play the processed audio data.

20. The computer readable storage medium of claim 18, wherein the decode unit further comprises a 4K decode subunit and an 8K decode subunit;
the operation of controlling the video recognition unit to recognize the 5G audio and video signals to send the recognized 5G audio and video signals to a corresponding decode unit comprises:
controlling the video recognition unit to recognize the 5G audio and video signals;
controlling the video recognition unit to send the 5G audio and video signals to the 4K decode subunit when the 5G audio and video signals are not 8K format; and
controlling the video recognition unit to send the 5G audio and video signals to the 8K decode subunit when the 5G audio and video signals are the 8K format.
